Europäisches Patentamt

European Patent Office

Office européen des brevets

(11) Veröffentlichungsnummer: **0 050 791**
**B1**

# EUROPÄISCHE PATENTSCHRIFT

(45) Veröffentlichungstag der Patentschrift: **11.02.87**

(51) Int. Cl.⁴: **H 01 L 41/08**

(21) Anmeldenummer: **81108294.0**

(22) Anmeldetag: **13.10.81**

(54) **Elektrisch zu betätigendes Stellglied.**

(30) Priorität: **28.10.80 DE 3040563**

(43) Veröffentlichungstag der Anmeldung:
**05.05.82 Patentblatt 82/18**

(45) Bekanntmachung des Hinweises auf die
Patenterteilung:
**11.02.87 Patentblatt 87/07**

(84) Benannte Vertragsstaaten:
**CH DE FR GB IT LI NL SE**

(56) Entgegenhaltungen:
**DE-B-2 329 502**

(73) Patentinhaber: **Siemens Aktiengesellschaft
Berlin und München
Wittelsbacherplatz 2
D-8000 München 2 (DE)**

(72) Erfinder: **Göpfert, Max
Schweidnitzer Strasse 43B
D-8000 München 50 (DE)**
Erfinder: **Kleinschmidt, Peter, Dipl.-Phys.
Klagenfurter Strasse 12
D-8000 München 90 (DE)**

EP 0 050 791 B1

Courier Press, Leamington Spa, England.

## Beschreibung

Die vorliegende Erfindung bezieht sich auf ein elektrisch zu betätigendes Stellglied, wie es im Oberbegriff des Patentanspruchs 1 angegeben ist.

Aus dem Stand der Technik ist ein Stellglied in der Ausführung eines Piezo-Motors zur Steuerung von Ventilen bekannt. Unter anderem ist dort ein aus einem Lamellenpaket bestehender piezoelektrischer Wandler angegeben, mit dem piezoelektrisch erzeugte Längenänderungen unter Kraftausübung erreicht werden.

Im Regelfall besteht ein Wandler für ein solches piezoelektrisches Stellglied aus Piezokeramik und insbesondere aus einem Stapel aufeinanderliegender Scheiben, die jeweils in Richtung ihrer Dicke polarisiert sind und parallel zur Polarisation elektrischen angeschlossen, werden. Um die eingeprägte Polarisation der Piezokeramik im Betrieb nicht zu zerstören, wird üblicherweise die elektrische Spannung mit einer solchen Polarität angeschlossen, daß sie die Polarisation der Keramik unterstützt. Dies bedeutet für eine Scheibe, daß sie sich mit Anliegen einer solchen elektrischen Spannung in Richtung der Dicke ausdehnt, d.h. der ganze Stapel eine Zunahme seiner Höhe erfährt. Damit kann mit der betriebsmäßig anzulegenden elektrischen Spannung Druckkraft vom Stellglied ausgeführt werden. Bei gleichem Verhältnis zwischen Polarisationsrichtung und Polarität der anzulegenden Spannung ergibt sich aber bei einem bereits erwähnten Paket aus piezokeramischen Lamellen keine Vergrößerung der Länge des Pakets — die Länge gemessen quer zur Richtung der Dicke der einzelnen Lamellen —, sondern eine Verkürzung, und zwar deshalb, weil hier der $d_{31}$-Effekt wirksam wird. Dieser $d_{31}$-Effekt hat außerdem den Nachteil, daß die Längenänderung des Lamellenpakets nur etwa 1/2 der gleichzeitig auftretenden Vergrößerung der Dicke des Lamellenpakets ausmacht. Wird jedoch das Lamellenpaket um ein Vielfaches länger als die Dicke einer einzigen Lamelle des Pakets gemacht, so erhält man dennoch vergleichsweise sehr viel größere Längenänderung als bei einem gleich langen Tablettenstapel.

Es ist eine Aufgabe der vorliegenden Erfindung, Maßnahmen anzugeben, mit denen ein im Betrieb Zug(und auch Druck)ausübender piezoelektrischer Wandler in der Form eines Lamellenpakets in einem elektrisch zu betätigenden Stellglied verwendet werden kann, und zwar als vorzugsweise direkte Kraft ausübendes (ohne Hebelübersetzung u. dergl. arbeitendes) Wandlerelement.

Diese Aufgabe wird für ein Stellglied nach dem Oberbegriff des Patentanspruchs 1 mit den erfindungsgemäßen Merkmalen des Kennzeichens des Patentanspruchs 1 gelöst.

Die Erfindung geht von den Feststellungen und der Überlegung aus, daß Stapel aufeinander geschichteter Scheiben für einen wie hier in Frage kommenden piezoelektrischen Wandler ungeeignet sind, insbesondere auch im Hinblick auf die zwischen den Scheiben befindlichen (Kleb)-schichten geringeren Elastizitätsmoduls. Die Erfindung geht davon aus, einen wie allerdings nur dem Prinzip nach vorgeschlagenen Wandler in der Form eines länglichen, insbesondere stabförmigen Lamellenpakets zu verwenden, in dem die einzelnen aneinandergefügten Lamellen einstückig vom einen bis zum anderen gegenüberliegenden Ende des Pakets reichen. Dabei muß aber, wie bereits erwähnt, für den im Regelfall in Frage kommenden Betrieb Zugspannung als Stellgröße des Wandlerelements berücksichtigt werden. Druckspannung erzeugende Betriebsprinzipien für ein solches Lamellenpaket erfordern einen gewissen größeren elektrischen Aufwand. Dieser Aufwand besteht z.B. darin, das Wandlerpaket mit einer elektrischen Vorspannung, die die Polarisation unterstützt, laufend zu beaufschlagen und den Stellvorgang durch Kurzschließen der Spannung oder Anlegen einer Gegenspannung durchzuführen.

Gemäß einem Merkmal der Erfindung ist vorgesehen, die Enden des Lamellenpakets mit einem Kraftübertragungselement zu verbinden, das z.B. eine Öse, einen Haken, ein Gewinde oder einen einzuspannenden Zapfen oder dergleichen haben kann, mit der bzw. mit dem auch Zugspannung übertragen werden kann. In diesem Zusammenhang ist zu beachten, daß der Bewegungshub eines solchen Stellgliedes sehr klein ist, und es muß deshalb eine toleranzfreie, feste Kopplung des Kraftübertragungselements mit dem im Kraftfluß folgenden Teil, wie z.B. einem Ventilstössel, möglich sein. Die Erfindung umfaßt Maßnahmen, mit denen die notwendige zugfeste Verbindung von Kraftübertragungselement und Endedes Wandlerpakets sicher und dauerhaft erreicht und gewährleistet werden kann.

Weitere Erläuterungen der Erfindung und insbesondere Ausführungsformen für eine derartige zugfeste Verbindung im Zusammenhang mit dem Aufbau des Lamellenpakets gehen aus der nachfolgenden, anhand der Figuren gegebenen Detailbeschreibung hervor.

Fig. 1 und 2 zeigen zwei Seitenansichten einer ersten Ausführungsform in Verschiedenen Varianten.

Fig. 3 und 4 zeigen Ausführungen für zwischen die Lamellen einzufügende Abstandshalter.

Fig. 5 bis 7 zeigen spezielle Ausführungen von Lamellen und Kraftübertragungselement untereinander.

Fig. 8 zeigt eine besondere Ausführungsform für Hochgeschwindigkeits-Verstellung.

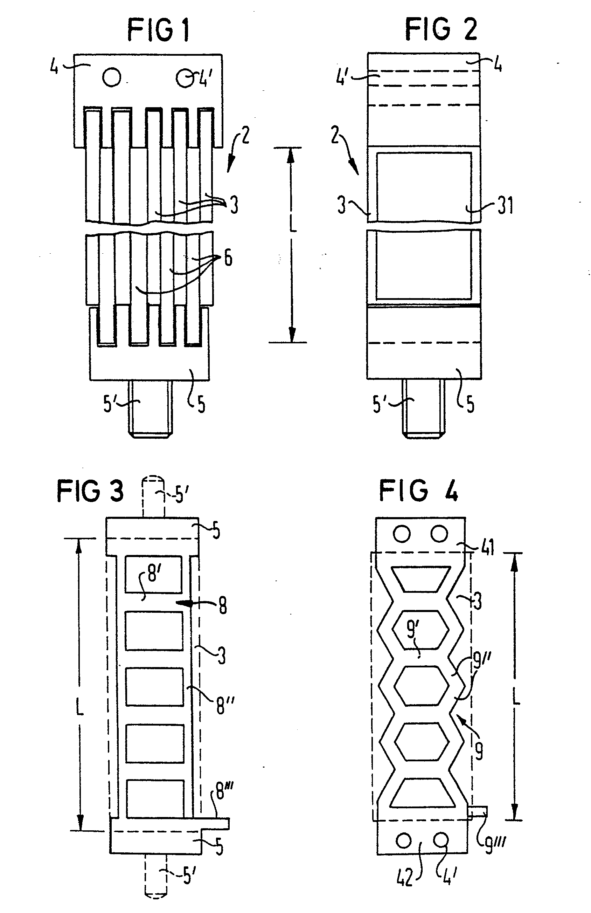

Die Fig. 1 und 2 zeigen in zwei verschiedenen Seitenansichten einen für ein Stellglied geeigneten Wandler 2, der piezokeramische Lamellen 3 hat. Mit 4 ist das eine und mit 5 ist das andere, jeweils an den beiden gegenüberliegenden Enden des Wandlers 2 fest angebrachte jeweilige Kraftübertragungselement bezeichnet.

Die Lamellen 3 bestehen aus Piezokeramik, wie z.B. Bleizirkonat-Titanat, das insbesondere durch Zugaben in an sich bekannter Weise bezüglich seiner piezoelektrischen Leistungsfähigkeit entwickelt ist und insbesondere relativ niedrige Schwinggüte hat (Bleizirkonat-Titanat mit Neodym-Zusatz). Aus der Fig. 1 ist bereits zu ersehen, daß das Paket des Wandlers 2 nicht ausschließlich aus solchen piezokeramischen Lamellen 3 besteht, sondern daß zwischen je zwei Lamellen auch ein Abstandshalter 6 vorgesehen sein kann, der den jeweiligen Zwischenraum zwischen zwei benachbarten Lamellen vollständig ausfüllt. Ebenso wie bei einem mit dicht aufeinanderliegenden Keramiklamellen ausgeführten Paket hat auch ein Wandler nach der Ausführungsform der Fig. 1 und 2 eine dichte Materialpackung. Entsprechend dem Dickenverhältnis zwischen der Dicke b der Keramiklamellen 3 und der Dicke d1 der Abstandshalter 6 hat ein derartiger Wandler 2 mit Abstandshaltern 6 entsprechend herabgesetzten Piezo-Effekt für die Längenausdehnung. Diese Herabsetzung des Piezo-Effekts ist aber keineswegs als Nachteil anzusehen, sondern ein solcher heterogen geschichteter Aufbau nach Fig. 1 hat eine besonders große Biegesteifigkeit infolge vergrößerter Breite b des Wandlers 2.

Die Lamellen 3 und vorzugsweise auch die Abstandshalter 6 erstrecken sich über die gesamte aktive Länge L des Wandlers 2 einstückig, d.h. ohne Unterbrechung.

Sofern die Abstandshalter 6 nicht ohnehin geringe Biegesteifigkeit in Richtung der Länge L haben, d.h. daß ein einzelner Abstandshalter 6 eine vergleichsweise zur einzelnen Keramiklamelle 3 wesentlich geringere Federsteifigkeit jeweils in Richtung L hat, haben die Abstandshalter auf die piezoelektrische Kraftausübung der Lamellen 3 keinen nennenswerten Einflüß. Eine obere Grenze für die Federsteifigkeit der Abstandshalter 6 in bezug auf die Lamellen 3 ist dann gegeben, wenn die jeweilige Federsteifigkeit etwa gleich groß wird. Die jeweilige Federsteifigkeit von Lamelle 3 und Abstandshalter 6 ergibt sich zum einen aus dem Elastizitätsmodul $E_K$ der Keramik der Lamelle 3 und aus dem insgesamt wirksamen Elastizitätsmodul $E_A$ des Abstandshalters. Für den Wert $E_A$ kommt entweder ein einheitlicher Wert bei einheitlichem Material des Abstandshalters in Betracht, oder es kann auch $E_A$ ein integraler Wert sein, der sich aus den entsprechenden Werten einzelner Komponenten ergibt, die zusammen den Abstandshalter 6 bilden.

Der Abstandshalter 6 kann z.B. ein Material wie geschäumtes Polyurethan oder geschäumtes Polystyrol sein, das dann zu bevorzugen ist, wenn geringste Federsteifigkeit und relativ große Dämpfung durch das Material des Abstandshalters 6 gewünscht ist. Der Abstandshalter 6 kann aber auch aus mehreren Komponenten zusammengesetzt sein, wie z.B. einem Glasfaservlies, das mit Epoxyharz, getränkt ist.

Ein weiteres Beispiel zur einer Ausführungsform eines Abstandshalters 6 zeigen die Fig. 3 und 4 in einer der Fig. 2 entsprechenden Ansicht. Die dargestellte Metallfolie 8, 9 bildet mit einseitig auf der Metallfolie oder beidseitig auf dieser befindlichem Kunstharz 6' den Abstandshalter 6. Die Ansichten der Fig. 3 und 4 lassen die leiterförmige Ausbildung der Metallfolien gemäß den Ausführungen 8 und 9 erkennen. Die Metallfolie 8 hat in Richtung der Länge L relativ breite Stege 8' und in Richtung quer zu L relativ schmale Längsstreifen 8''. Die Bemessung der Längsstreifen 8'' ergibt eine relativ geringe Federsteifigkeit in Richtung L. Auch die Stege 8' tragen zur Federsteifigkeit in Richtung L nichts bei, da die Summe der Werte der Breite der Einzelnen Querstege 8' noch klein gegenüber der Gesamtlänge L ist. Die Stege 8' wirken aber in vorteilhafter Weise in Richtung quer zur Länge L, d.h. parallel zur Breite der Lamellen 3. Sie behindern eines Ausdehnung (und auch Kontraktion) in Richtung der Breite der Lamelle. Dies kommt dem wirksam werdenden piezoelektrischen Quereffekt in Richtung L zugute, d.h. verstärkt die piezoelektrische Kraftwirkung und das Maß der piezoelektrischen Längenänderung $\Delta L$ des Wandlers 2. Das zu den Querstegen 8' Gesagte gilt auch für die Querstege 9' der Metallfolie 9 der Fig. 4. Zur weiteren Herabsetzung der Federsteifigkeit der Metallfolie 9 in Richtung L sind die in Fig. 3 geradlinigen Längsstreifen 8'' hier als geknickte Streifen 9'' ausgebildet.

Die Fig. 3 und 4 zeigen mit 8''' bzw. 9''' bezeichnete Anschlußfahnen für die elektrische Spannungszuführung, die dann als solche verwendbar sind, wenn eine elektrische Verbindung zwischen den Metallfolien 8 oder 9 und der Oberflächenelektrode der Lamellen 3 gegeben ist. Diese Oberflächenelektroden sind oberflächliche Metallisierungen, z.B. Einbrennversilberung, der einander gegenüberliegenden, senkrecht zur Dicke d sich erstreckenden Oberflächen. Wegen der hohen Dielektrizitätskonstante des piezokeramischen Materials ist es erforderlich, daß die für die Lamelle wirksam werdende jeweilige Elektrode dicht auf der Oberfläche der Lamelle aufliegt. Besonders günstig in dieser Hinsicht sind aufgesputterte oder chemisch abgeschiedene Metallschichten.

In Fig. 1 ist rein schematisch zu sehen, wie die Verbindung zwischen dem jeweiligen Kraftübertragungselement 4, 5 und dem Wandler 2 ausgeführt sein kann. Als ein Beispiel ist eine solche Verzinkung zwischen Wandler 2 und Kraftübertragungselement 4 vorgesehen, bei dem die Keramiklamellen 3 und Zinken des Elements 4 wie ersichtlich ineinandergreifen. Der Vorteil einer solchen Ausführung mit Zinken ist die, daß die Keramik der Lamelle 3 und das Material der Zinken des Elements 4 seitlich miteinander verklebt sind und Zugkräfte des Wandlers 2 auf das Element 4 sich in der Verbindung als Scherkräfte zwischen den jeweiligen Zinken-Seitenoberflächen bemerkbar machen. Es können vorteilhafterweise — wie ersichtlich — die (seitlichen) Verbindungsflächen zwischen einer einzelnen Lamelle und einer einzelnen Zinke des Elements um ein Vielfaches größer gemacht werden, als es die Verbindungsfläche bei nur stirnseitiger Verbindung von Lamellen-Ende und Kraftübertragungselement 4 wäre.

Die Verbindung zwischen dem Wandler 2 und dem Kraftübertragungselement 5 — wie in Fig. dargestellt — unterscheidet sich als weiteres Beispiel von der für das obere Ende 4 dargestellten darin, daß hier die Abstandshalter mit den Zinken des Kraftübertragungselements 5 in der Weise verbunden sind, wie dies oben für die Keramiklamellen 3 beschrieben worden ist. Es kann wahlweise am einen oder auch an beiden Enden 4, 5 die eine oder die andere Verbindungsform vorgesehen sein.

Zwei verschiedene Alternativen für eine Ausführungsform des Kraftübertragungselements 4, 5, und zwar im Hinblick auf die Weiterleitung des Kraftflusses, sind in der Fig. 1 ebenfalls enthalten. Das Kraftübertragungselement 4 hat eine oder mehrere Öse(n) 4' und das Kraftübertragungselement 5 weist einen Gewindebolzen 5' auf. Diese Ösen 4' können z.B. in der Gesamtheit der vorhandenen Metallfolien vorgesehen sein, wie dies für eine Folie der Fig. 4 bezeigt ist. Das obere und untere, die Länge L überragende jeweilige Ende 41 und 42 der Folie 9 hat je zwei diesen Ösen 4' entsprechende Löcher, und die Enden 41 bilden zusammen das Kraftübertragungselement 5 und die Enden 42 bilden zusammen das Kraftübertragungselement 5. Bei einer solchen Ausführungsform kann die Länge der Keramiklamellen 3 auf die Länge L vorzugsweise beschränkt sein. Die Ende 41 und 42 können z.B. zu einem klotzartigen Körper miteinander verlötet, verklebt oder mit Zusatzteilen ganz oder teilweise ausgefüllt und/ oder zusätzlich verklebt sein. Etwas gleiches kann für die Gesamtheit der Metallfolien 8 nach Fig. 3 in einem Wandler 2 vorgesehen sein. Die Gesamtheit der oberen Enden aller Folien 8 eines Wandlers 2 können das eine Kraftübertragungselement 4 und die Gesamtheit der anderen Enden der Folien 8 können das andere Kraftübertragungselement 5 bilden, wobei an diese beiden Enden ein wie gestrichelt angedeuteter Gewindebolzen angesetzt sein kann.

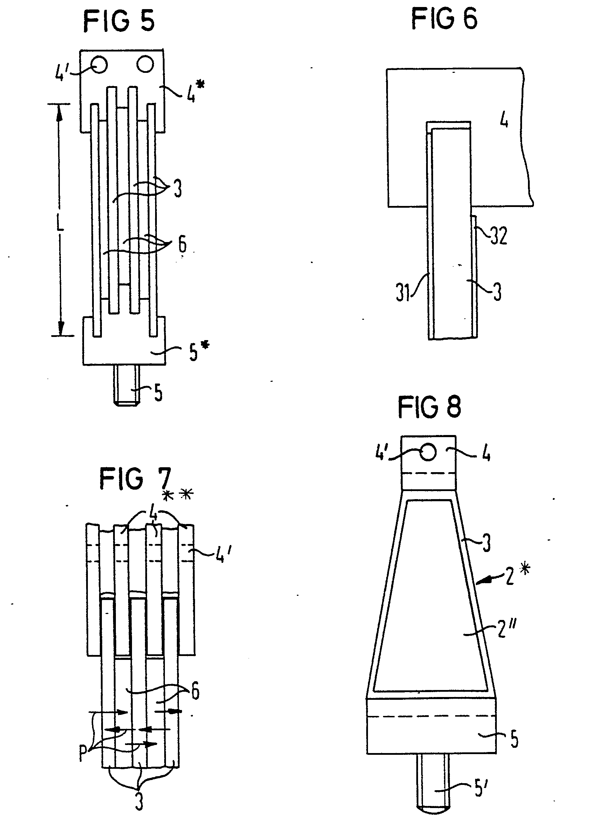

Fig. 5 zeigt noch eine Weiterbildung einer Ausführungsform für die Verbindung von Lamellenpaket des Wandlers 2 mit den Kraftübertragungselementen 4' und 5'. Wie ersichtlich, sind alle Lamellen 3 untereinander gleich lang. Sei sind aber gegeneinander in Richtung der Länge L versetzt angeordnet, damit ihre Einspannteile in den Elementen 4* und 5* nicht jeweils auf gleicher Höhe liegen, womit die Druckfestigkeit an dieser Stelle erheblich verringert werden kann. Die Zinken der Elemente 4* und 5* haben entsprechend unterschiedliche Länge, wobei beim Element 4* der längste Zinken jeweils außen und beim Element 5* der längste Zinken innen in bezug auf das Paket liegt. Zwischen den Lamellen 3 befindet sich Material, das den bereits beschriebenen Abstandshalter 6 bildet und der sinngemäß auch nach den Fig. 3 und 4 mit Metallfolie ausgebildet sein kann.

Wie bereits oben erwähnt, besitzen die Lamellen Elektroden auf ihren Oberflächen. Fig. 6 zeigt in Vergrößerung eine Ausschnittsdarstellung, die zeigt, wie die Elektrode 31 der einen Oberflächenseite der Lamelle 3 in das Kraftübertragungselement 4 hineinragt, das hier vorzugsweise aus Metall besteht. Die Elektrode 32 reicht dagegen nicht einmal bis an das Element 4 heran und ist dementsprechend gegenüber dem Element 4 elektrisch isoliert. Die Elektrode 32 kann aber ebenso wie die Elektrode 31 in das Element 4 in das am anderen unteren Ende der Lamelle 3 (nicht dargestellt) Element 5 hineinragen. Auf diese Weise kann der elektrische Anschluß für die Elektroden der Lamelle 3 so ausgeführt sein, daß das Element 4 den einen gemeinsamen Anschluß für alle Lamellen bildet und das Element 5 den anderen gemeinsamen Anschluß ergibt.

Fig. 7 zeigt als Beispiel eine weitere Ausführungsform, nämlich zum einen für das Kraftübertragungselement und zum anderen für die Abstandshalter. Wie dargestellt, besteht das Kraftübertragungselement aus einer Anzahl einzelner Streifenstücke 4**, die Löcher 4' als Ösen haben. Zu einem Anteil liegen diese Streifenstücke 4** zwischen den Lamellen 3. Die sich zwischen diesen Streifenstücken 4** außerhalb des Bereichs der Lamellen 3 ergebenden Zwischenräume können z.B. mit Kunstharz vergossen sein, das insbesondere einen harten Füllstoff enthält. Der Zwischenraum kann auch durch Verklebung oder Verlötung ausgefüllt sein, wobei zusätzlich aus Metall, Keramik, Kunststoff oder dergl. bestehende Zusatzteile eingefügt sein können.

Die Fig. 7 zeigt außerdem noch als Beispiel die Ausführungsform, bei der die Abstandshalter 6 zwischen den Lamellen 3 ebenfalls piezokeramische Lamellen sind. Diese zusätzlichen piezokeramischen Lamellen sind flächenmäßig mit den beidseitig jeweils anliegenden Lamellen 3 verbunden, so daß piezoelektrische Kraftwirkung, die in den zusätzlichen, die Abstandshalter 6 bildenden piezoelektrischen Lamellen entsteht, über die Lamellen 3 auf das Kraftübertragungselement übertragen werden kann. Vorzugsweise haben die ohnehin vorhandenen Lamellen 3 und die zusätzlichen, die Abstandshalter 6 bildenden Lamellen jeweils gleich große Dicke d, und auch die Streifenstücke 4** haben eine Dicke d. Zwischen den aufeinanderliegenden Lamellen befindlicher Klebstoff bzw. Vergußmasse dient außerdem dazu, gewisse Dickentoleranzen auszugleichen. Zur piezoelektrischen Anregung der zusätzlichen, die Abstandshalter 6 bildenden Lamellen ist vorgesehen, daß deren Oberflächen ebenso wie die Lamellen 3 eine Elektrodenmetallisierung haben. Wenn man zusätzlich noch die Polarisationsrichtung P in den zusätzlichen Lamellen jeweils entgegengesetzt der Polarisationsrichtung P in den Lamellen 3 wählt, können die jeweils aufeinanderliegenden Oberflächen einer Lamelle 3 und einer zusätzlichen, den Abstandshalter 6 bildenden Lamelle eine gemeinsame Elektrode sein.

Diese zusätzlichen Lamellen unterstützen dann in einfacher Weise die Kraftwirkung der ohnehin vorgesehenen Lamellen 3.

Fig. 8 zeigt eine der Fig. 2 entsprechende Seitenansicht eines Stellgliedes mit trapezförmigem Wandler 2*; die der Fig. 1 entsprechende Ansicht dieser Ausführungsform unterscheidet sich nicht von der Fig. 1. Die Elektrode 2'ist hier entsprechend trapezförmig. Wenn dieses Stellglied nach Fig. 8 mit seinem breiten Ende, d.h. mit dem Kraftübertragungselement 5, mit der Masse einer Vorrichtung oder eines Gerätes verbunden ist und am Kraftübertragungselement 5 dementsprechend praktisch keine Bewegung auftritt, hat die Ausführungsform nach Fig. 8 den Vorteil, das dasjenige Ende des Stellgliedes, an dem sich das Kraftübertragungselement 4 befindet, raschere Wechselbewegungen ausführen kann, als dies vergleichsweise für eine Ausführungsform nach den Fig. 1 und 2 der Fall wäre. Das Stellglied mit dem Wandler 2* hat in dem Bereich, wo hohe Geschwindigkeiten auftreten, vergleichsweise weniger Masse als an dem Kraftübertragungselement 5 nahe liegenden Anteilen des Wandlers 2*. Es ist damit auch keine Einbuße an Stellkraft verbunden, da der Beitrag von Anteilen des Wandlers 2* im Bereich hoher Geschwindigkeiten desselben ohnehin geringer ist.

## Patentansprüche

1. Elektrisch zu betätigendes. Stellglied mit einem Wandler zusammengesetzt aus einer Anzahl mit Elektroden versehener, in Betätigungsrichtung einstückiger Lamellen aus Piezokeramik-Material, die mit zwischen den Lamellen vorgesehenen Abständen zu einem Paket vereinigt sind, wobei die Länge der Lamellen mindestens 5 mal so groß wie die Dicke der einzelnen Lamelle ist, die Lamellen alle gleiche Dicke haben und die Lamellen über die Abstände hinweg gegeneinander unverschiebbar miteinander verbunden sind und wobei sich deren Länge zwischen ihren Enden bei Anlegen elektrischer Spannung abhängig vom Vorzeichen dieser Spannung und Polarisation des Materials verkürzt und verlängert, gekennzeichnet dadurch, daß die zwischen je zwei Lamellen (3) vorhandenen Zwischenräume mit je einem solchen lamellenartigen Abstandshalter (6) ausgefüllt sind, der aus einem Material besteht, mit dem der einzelne Abstandshalter (6) eine Federsteifigkeit (F) zwischen den Enden des Pakets hat, die kleiner ist als die zwischen diesen Enden vorliegende Federsteifigkeit einer einzelnen jeweiligen Lamelle aus Piezokeramik,
daß an den beiden Enden des Lamellenpakets (2) je ein Zugkräfte des Pakets (2) übertragendes Kraftübertragungselement (4, 5) fest angebracht ist und
daß diese Kraftübertragungselemente (4, 5) und das jeweilige Ende des Lamellenpakets (2) miteinander verzinkt verbunden sind, wobei die Länge der Zinken wenigstens gleich dem fachen der Dicke einer einzelnen der Lamellen ist.

2. Stellglied nach Anspruch 1, gekennzeichnet dadurch, daß im jeweiligen Zwischenraum ein Streifen aus mit Kunstharz getränktem Glasfaservlies vorgesehen ist.

3. Stellglied nach Anspruch 1, gekennzeichnet dadurch, daß der jeweilige Zwischenraum durch Kunstharz und mit einem darin eingebetteten Metallstreifen (8, 9) in Leiterform mit quer verlaufenden Stegen (8', 9') und mit dazu relativ dünnen Längsstreifen (8'', 9'') gebildet ist.

4. Stellglied nach Anspruch 2 oder 3, gekennzeichnet dadurch, daß die Streifen (8, 9) die Enden der Lamellen (3) derart überragen, daß diese überragenden Anteile der Streifen zusammen einen Kopf als Zug-Kraftübertragungselement (4, 5) bilden.

5. Stellglied nach einem der Ansprüche 1 bis 4, gekennzeichnet dadurch, daß das Kraftübertragungselement (4, 5) durch Streifenstücke (4**) gebildet ist (Fig. 7), die sich mit jeweils einem ersten Anteil bis zwischen die Lamellen (3) das Lamellenpakets (2) erstrecken und deren restlicher Anteil das Lamellenpaket überragt.

6. Stellglied nach Anspruch 4 oder 5, gekennzeichnet dadurch, daß zwischen den überragenden Anteilen der Streifen (8, 9) bzw. Streifenstücke (4**) die Zwischenräume ausfüllendes Material eingefügt ist.

7. Stellglied nach einem der Ansprüche 1 bis 6, gekennzeichnet dadurch, daß der Abstandshalter (6) wenigstens zu einem Anteil aus einem solchen Material besteht, das für Stellschwingungen des Pakets dämpfende Eigenschaft hat.

8. Stellglied nach einem der Ansprüche 1 bis 7, gekennzeichnet dadurch, daß bei elektrisch leitfähigem Kraftübertragungselement (4) die jeweils eines Elektrode (31) der jeweiligen einzelnen Lamellen (3) zusammen mit dieser Lamelle (3) in die Zinkung des Kraftübertragungselements (4) für eine elektrische Verbindung dieser Elektrode (31) mit dem Kraftübertragungselement (4) hereinragt (Fig. 6).

9. Stellglied nach einem der Ansprüche 1 bis 8, gekennzeichnet dadurch, daß die Lamellen (3) und gegebenenfalls vorgesehene Abstandshalter (6) eine Trapezform haben (Fig. 8).

## Revendications

1. Organe de réglage à commande électrique, avec un transducteur formé par une pluralité de lamelles d'une pièce en un matériau piézoélectrique, pourvues d'électrodes et assemblées en un paquet avec des intervalles prévus entre les lamelles, la longueur des lamelles étant au moins égale à 5 fois l'épaisseur des lamelles individuelles, les lamelles ayant toutes une même épaisseur et étant reliées entre elles de manière à pouvoir se décaler l'une par rapport à l'autre au-delà desits intervalles, alors que leur longueur entre leurs extrémités diminue. ou augmente lors de l'application d'une tension électrique, en fonction du signe de cette tension et de la polarisation du matériau, caractérisé par le fait que les intervalles prévus respectivement entre deux lamelles (3) sont chacun comblés avec une entretoise lamellaire (6) qui est constituée avec un matériau avec lequel chaque entretoise individuelle (6) possède, entre les extrémités du paquet, une résistance à la flexion qui est inférieure à la résistance à la flexion, entre ces extrémités, d'une lamelle individuelle en une céramique piézoélec- trique, qu'aux deux extrémités du paquet de lamelles (2) est fixé respectivement un élément (4, 5) de transmission des forces transmettant des forces de traction du paquet (2), et que ces éléments (4, 5) de transmission des forces et l'extrémité correspondante du paquet de lamelles (2) sont reliées par des tenons, la longueur destenons étant au moins égale à la triple épaisseur des lamelles individuelles.

2. Organe de réglage selon la revendication 1, caractérisé par le fait que dans chaque intervalle est prévue une bande d'un voile de fibres de verre, imprégné d'une résine synthétique.

3. Organe de réglage selon la revendication 1, caractérisé par le fait que chaque intervalle est constitué par une résine synthétique avec, noyées dans celle-ci, des bandes métalliques (8, 9) ayant la forme de conducteurs avec des barrettes (8', 9') s'étendant transversalement, et avec des bandes longitudinales (8'', 9'') relativement minces par rapport auxdites barrettes.

4. Organe de réglage selon la revendication 2 ou 3, caractérisé par le fait que les bandes (8, 9) débordent les extrémités des lamelles (3) de manière que ces parties des bandes débordantes forment ensemble une tête qui constitue un élément de transmission des forces de traction (4, 5).

5. Organe de réglage selon l'une des revendications 1 à 4, caractérisé par le fait que l'élément de transmission des forces (4, 5) est constitué par des pièces de bandes (4**) (figure 7) qui s'étendent, avec respectivement une première partie, jusqu'entre les lamelles (3) du paquet de lamelles (2) et dont la partie qui reste déborde le paquet de lamelles.

6. Organe de réglage selon la revendication 4 ou 5, caractérisé par le fait qu'entre les parties débordantes des bandes (8, 9) ou les pièces de bandes (4**), un matériau est inséré qui comble les intervalles.

7. Organe de réglage selon l'une des revendications 1 à 6, caractérisé par le fait que l'entretoise (6) est constituée, au moins en partie, par un matériau qui possède une propriété d'amortissement pour les oscillations de réglage du paquet.

8. Organe de réglage selon l'une des revendications 1 à 7, caractérisé par le fait que dans le cas d'éléments de transmission des forces (4), qui est capable de conduire l'électricité, une électrode (31) associée à chacune des lamelles individuelles (3), pénètre, avec cette lamelle (3) dans la liaison par tenons de l'élément de transmission des forces (4), en vue d'établir une liaison électrique entre cette électrode (31) avec l'élément de transmission de forces (4) (figure 6).

9. Organe de réglage selon l'une des revendications 1 à 8, caractérisé par le fait que les lamelles (3) et éventuellement des entretoises (6) qui seraient prévues, présentent la forme d'un trapèze (figure 8).

## Claims

1. An electrically operated regulating unit comprising a transducer, which comprises a number of laminations made of a piezo-ceramic material in one piece in the direction of operation and provided with a number of electrodes, and which together with spacings provided between the laminations are combined to form a package, where the length of the laminations is at least 5 times as great as the thickness of the individual lamination, the laminations have the same thickness and the laminations are connected to one another so as to be non-displaceable relative to one another across the spacings and where upon connection of an electric voltage the length of which laminations is shortened or extended between their ends in dependence upon the sign of the voltage and polarisation of the material, characterised in that the interspaces which are respectively arranged between two laminations (3) are respectively filled with a laminar spacer (6) of such a kind which comprises a material, by means of which the individual spacer (6) has a spring stiffness (F) between the ends of the package which is smaller than the spring stiffness which prevails between the ends of one single lamination made of piezo-ceramic, that a force transfer element (4, 5) which transfers tensile forces of the package (2) is firmly fixed to each of thetwo ends of the lamination package (2), that the force transfer elements (4, 5) and the respective end of the lamination package (2) are mortise and tenoned to one another, where the length of the tenon is at least equal to the threefold thickness of one single lamination.

2. A regulating unit as claimed in claim 1, characterised in that each respective interspace is provided with a strip made of a glass fibre fleece which is saturated with synthetic resin.

3. A regulating unit as claimed in claim 1, characterised in that the respective interspace comprises synthetic resin and has a metal strip (8, 9) which is embedded therein, in the form of a conductor with transversely extending crosspieces (8', 9') and has longitudinal strips (8'', 9'') which are relatively thin compared thereto.

4. A regulating unit as claimed in claim 2 or 3, characterised in that the strips (8, 9) protrude over the ends of the laminations (3) in such a manner that the protruding portions of the strips together form a head as a tensile-force transfer element (4, 5).

5. A regulating unit as claimed in one of claims 1 to 4, characterised in that the force transfer element (4, 5) is formed by strip pieces (4**) (Fig. 7) which together with a first portion respectively extend to between the laminations (3) of the lamination package (2) and whose residual portion protrudes over the lamination package.

6. A regulating unit as claimed in claim 4 or 5, characterised in that material filling the interspaces is inserted between the protruding portions of the strips (8, 9) or the strip pieces (4**).

7. A regulating unit as claimed in one of claims 1 to 6, characterised in that at least part of the spacer (6) comprises a material of such a kind that exhibits properties attenuating regulating oscillations of the package.

8. A regulating unit as claimed in one of claims 1 to 7, characterised in that in the case of an electrically conductive force transfer element (4) the respective one electrode (31) of the respective individual lamination (3) together with said lamination (3) protrudes into the mortising of the force transfer element (4) for an electrical connection of said electrode (31) with the force transfer element (4) (Fig. 6).

9. A regulating unit as claimed in one of claims 1 to 8, characterised in that the laminations (3) and possibly provided spacers (6) have a trapezoidal shape (Fig. 8).

FIG 1

FIG 2

FIG 3

FIG 4

# FIG 5

# FIG 6

# FIG 7

# FIG 8